# EUROPEAN PATENT APPLICATION

(11) **EP 3 522 691 A1**
(43) Date of publication of application: **07.08.2019**
(21) Application number: 19152725.8
(22) Date of filing: 21.01.2019
(51) Int. Cl.: H05K 7/20

(54) **SEMICONDUCTOR APPARATUS**

(30) Priority: 02.02.2018 JP 2018017442
(71) Applicant: Kabushiki Kaisha Toyota Jidoshokki, Kariya-shi, Aichi 448-8671 (JP)
(72) Inventor: YOSHIKAWA, Kaoru, Kariya-shi,, Aichi 448-8671 (JP); ITO, Kenichiro, Kariya-shi,, Aichi 448-8671 (JP); KONTANI, Kazuyoshi, Kariya-shi,, Aichi 448-8671 (JP)
(74) Representative: TBK

(57) **Abstract**

A semiconductor apparatus (10) includes a heat release member (11), a first substrate (20) that is fixed to the heat release member (11) and on which a semiconductor device (24) is mounted, a second substrate (60) that is spaced from the first substrate (20) in a thickness direction of the first substrate (20) and on which an electronic component is mounted, and a bracket (70) that fixes the second substrate (60) to the heat release member (11). An electrically non-conductive heat transfer member (91) is disposed between the second substrate (60) and the bracket (70) for transferring heat from the second substrate (60) to the bracket (70). The bracket (70) is made of a metal. The bracket (70) includes a heat transfer portion (81, 82, 85) that transfers heat to the heat release member (11).

## Description

### BACKGROUND ART

The present disclosure relates to a semiconductor apparatus.

A semiconductor apparatus includes electronic components such as a semiconductor device, a substrate on which the electronic components are mounted, a heat release member releasing heat generated by the electronic components. If all the electronic components are mounted on one substrate, the size of the semiconductor apparatus may be increased because the size of the substrate in the direction along the surface of the substrate in the thickness direction (direction extending perpendicularly to the thickness direction) need to be increased.

PCT International Publication No. WO2014/057622 discloses a semiconductor apparatus that includes a plurality of substrates. The substrates are spaced from each other in the thickness direction thereof. The semiconductor apparatus includes a fixing member fixing the substrates with their spaced distance from each other maintained. The electronic components are disposed dispersedly on the substrates. The provision of the plurality of substrates spaced from each other in the thickness direction thereof may restrict an increase in size of the semiconductor apparatus. The semiconductor apparatus includes a metal plate that is connected to each substrate and the heat release member. Thus, heat generated by the electronic components and each substrate is transferred to the heat release member through the metal plate.

However, the semiconductor apparatus of the Publication includes a metal plate for transferring heat from each substrate to the heat release member, which may increase the size of the semiconductor apparatus.

The present disclosure direct to providing a semiconductor apparatus while restricting an increase in size of the semiconductor apparatus.

### SUMMARY

In accordance with the present disclosure there is provided a semiconductor apparatus including a heat release member, a first substrate that is fixed to the heat release member and on which a semiconductor device is mounted, a second substrate that is spaced from the first substrate in a thickness direction of the first substrate and on which an electronic component is mounted, and a bracket that fixes the second substrate to the heat release member. An electrically non-conductive heat transfer member is disposed between the second substrate and the bracket for transferring heat from the second substrate to the bracket. The bracket is made of a metal. The bracket includes a heat transfer portion that transfers heat to the heat release member.

Other aspects and advantages of the disclosure will become apparent from the following description, taken in conjunction with the accompanying drawings, illustrating by way of example the principles of the present disclosure.

### BRIEF DESCRIPTION OF THE DRAWINGS

The disclosure together with objects and advantages thereof may best be understood by reference to the following description of the presently preferred embodiments together with the accompanying drawings in which:
FIG. 1 is an exploded perspective view of a semiconductor apparatus according to a present disclosure;
FIG. 2 is a cross-sectional view of the semiconductor apparatus of FIG. 1;
FIG. 3 is a perspective view of a bracket;
FIG. 4 is a plan view of the semiconductor apparatus;
FIG. 5 is a plan view of the semiconductor apparatus in which a control substrate is shown by an imaginary line;
FIG. 6A, 6B, and 6C are cross-sectional views of the semiconductor apparatus showing fastening of each substrate by screws; and
FIG. 7 is a side view of the semiconductor apparatus.

### DETAILED DESCRIPTION OF THE EMBODIMENTS

The following will describe an embodiment of a semiconductor apparatus of the present disclosure with reference to the accompanying drawings. The semiconductor apparatus of the present embodiment corresponds to an inverter to be mounted to a battery-powered industrial vehicle (e.g., forklift truck). The inverter converts direct current power from a battery to alternating current power (three-phase alternating current) and outputs such alternating current power to a three-phase electric motor to drive the three-phase electric motor.

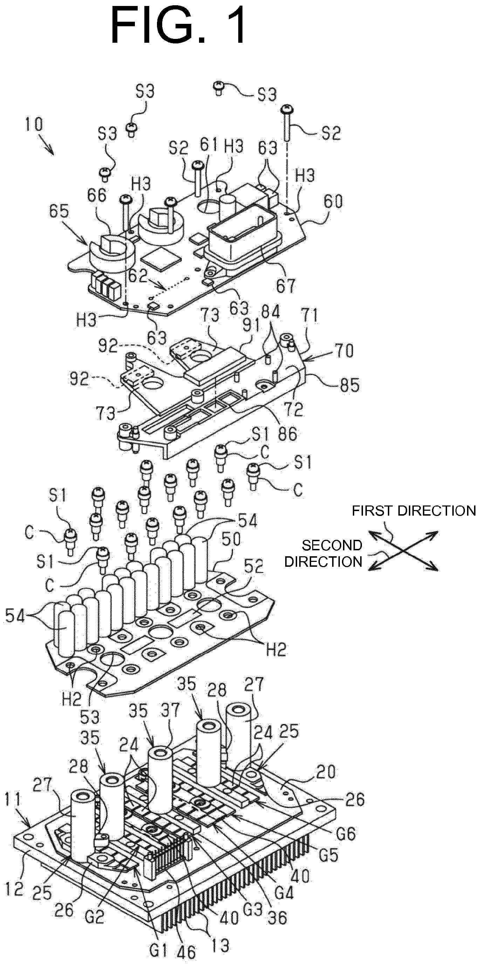

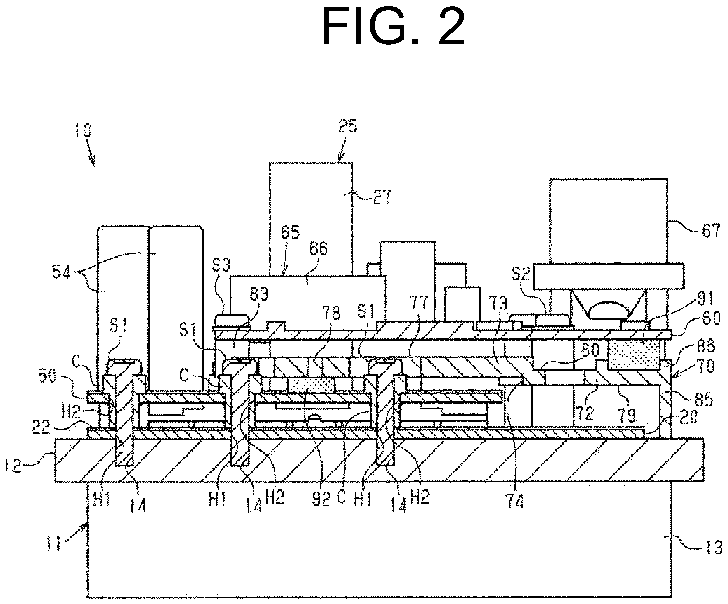

As shown in FIGS. 1 and 2, a semiconductor apparatus 10 includes a heat sink 11 as a heat release member. The heat sink 11 is made of a metal such as aluminum-based metal and copper. The heat sink 11 includes a fixing member 12 that has a plate shape and a fin 13 that projects from one of the end surfaces of the fixing member 12 in the thickness direction thereof. The fixing member 12 is formed with a plurality of screw holes 14. A screw groove (female threaded groove) is formed in the inner peripheral surface of the screw hole 14.

The semiconductor apparatus 10 includes a power substrate 20, a control substrate 60, and a capacitor substrate 50. The power substrate 20, the control substrate 60, and the capacitor substrate 50 correspond to the first, second and third substrates, respectively, of the present disclosure. The control substrate 60 is spaced from the power substrate 20 in the thickness direction of the power substrate 20. The capacitor substrate 50 is disposed between the power substrate 20 and the control substrate 60. The thickness direction of the power substrate 20 coincides with the thickness direction of the control substrate 60 and the thickness direction of the capacitor substrate 50. It may be said that the heat sink 11 and the three substrates 20, 50, 60 are disposed in layers.

The power substrate 20 is fixed to one of the opposite surfaces of the fixing member 12 in the thickness direction that is opposite from the surface in which the fin 13 is formed. The power substrate 20 of the present embodiment is formed by an insulation metal substrate (IMS), which has an insulation layer formed on a metal base. The power substrate 20 includes a conductor pattern 22. A plurality of first insertion holes H1 is formed through the power substrate 20 in the thickness direction thereof.

The semiconductor apparatus 10 includes a plurality of semiconductor devices 24, two input terminals 25, three output terminals 35, two spacers 40, and a pin-header 46. The semiconductor devices 24, the two input terminals 25, the three output terminals 35, the two spacers 40, and the pin-header 46 are mounted on the power substrate 20. The semiconductor devices 24 of the present embodiment are MOSFET, but a switching element other than MOSFET (e.g. insulated gate bipolar transistor) may be used as the semiconductor device 24. The semiconductor devices 24 are divided in six semiconductor device groups G1, G2, G3, G4, G5, G6 and disposed on the power substrate 20. In each semiconductor device group G1, G2, G3, G4, G5, G6, the semiconductor devices 24 are arranged in a line. In the following description, the direction in which the semiconductor devices 24 are arrange in a line in each semiconductor device group G1, G2, G3, G4, G5, G6 is referred to as the first direction.

The semiconductor device groups G1, G2, G3, G4, G5, G6 are spaced from each other. Specifically, the semiconductor device groups G1, G2, G3, G4, G5, G6 are disposed in a direction extending to cross the first direction of the directions extending along the thickness direction of the power substrate 20. In the following description, the direction in which the semiconductor device groups G1, G2, G3, G4, G5, G6 are arranged will be referred to as the second direction. The semiconductor device groups G1, G2, G3, G4, G5, G6 form the three-phase upper-lower arm of the inverter.

The two input terminals 25 and the three output terminals 35 are spaced apart from each other in the second direction. The two input terminals 25 are arranged with the semiconductor device groups G1, G2, G3, G4, G5, G6 disposed therebetween. Thus, the input terminals 25 are disposed closer to the outer edge of the power substrate 20 than the semiconductor device groups G1, G2, G3, G4, G5, G6 are in the second direction. The three output terminals 35 are disposed between the two input terminals 25. The input terminal 25 includes a base portion 26, a pillar 27 projecting from the base portion 26, and a seat portion 28 projecting from the peripheral surface of the pillar 27. The output terminal 35 includes a base 36 and a pillar 37 projecting from the base 36. The input terminal 25 and the output terminal 35 are made of a metal such as aluminum-based metal and copper. The base portion 26 of the input terminal 25 and the base 36 of the output terminal 35 are connected to the conductor pattern 22 of the power substrate 20. A battery is connected to the input terminal 25. A three-phase electric motor is connected to the output terminal 35. The two spacers 40 are disposed along the second direction and spaced from each other. Each spacer 40 is disposed between the output terminals 35. The spacer 40 is made of a metal such as aluminum-based metal and copper. The pin-header 46 is disposed closer to the outer edge of the power substrate 20 than the semiconductor device groups G1, G2, G3, G4, G5, G6 are in the first direction.

The capacitor substrate 50 is disposed on the base portion 26 of the input terminal 25, the base 36 of the output terminal 35, and the spacer 40. The capacitor substrate 50 has a conductor pattern 52. The capacitor substrate 50 has an output hole 53 through which the pillar 37 of the output terminal 35 is inserted. The capacitor substrate 50 has a plurality of second insertion holes H2 formed through the capacitor substrate 50 in the thickness direction thereof. The capacitor substrate 50 and the power substrate 20 are electrically connected through the base portion 26 of the input terminal 25 and the spacer 40.

The semiconductor apparatus 10 is provided with a plurality of capacitors 54 mounted on the capacitor substrate 50. In the present embodiment, the capacitors 54 are gathered in one end of the capacitor substrate 50. Specifically, the plurality of capacitors 54 is disposed along one end of the capacitor substrate 50 of the opposite ends thereof in the first direction thereof. The capacitor 54 has a columnar shape and is mounted on the capacitor substrate 50 so that the axis of the capacitor 54 coincides with the thickness direction of the capacitor substrate 50. In other words, the capacitor 54 is disposed on the capacitor substrate 50 in a standing manner.

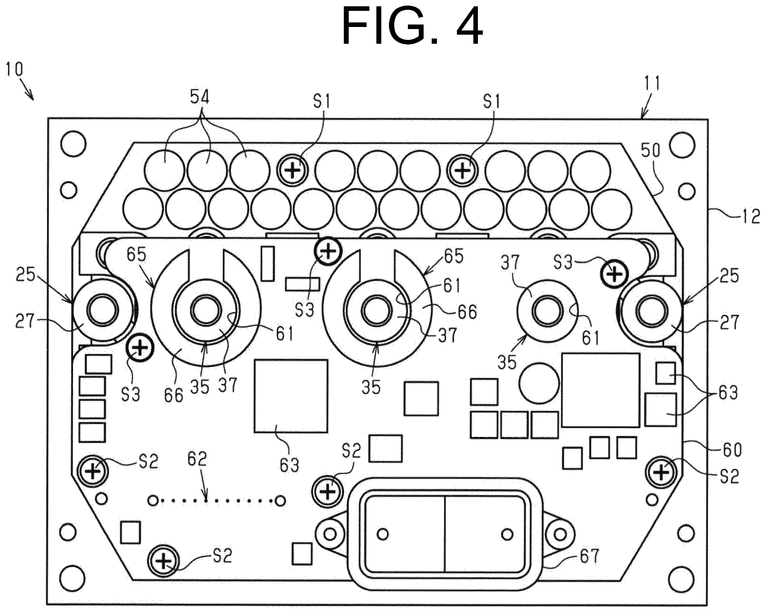

As shown in FIGS. 1, 2, and 4, the control substrate 60 has three output holes 61 formed through the control substrate 60 in the thickness direction thereof. The pillar 37 of the output terminal 35 is inserted through each output hole 61. The control substrate 60 is formed with a through hole 62 through which the pin-header 46 is inserted. The control substrate 60 has a plurality of third insertion holes H3 formed through the control substrate 60 in the thickness direction thereof. The semiconductor apparatus 10 includes a plurality of electronic components 63, an electric current sensor 65, and a connecting portion 67 mounted on the control substrate 60. The electronic components 63 form a control circuit that controls the semiconductor device groups G1, G2, G3, G4, G5, G6. Power conversion is carried out by controlling (switching control) of the semiconductor device groups G1, G2, G3, G4, G5, G6 by the control circuit.

The insertion of the pin-header 46 into the through hole 62 connects the control substrate 60 and the power substrate 20. The electric current sensors 65 are provided for two of the three output terminals 35. The electric current sensor 65 includes a core 66 and a hole element (not shown). The connecting portion 67 is provided on one of the opposite surfaces in the thickness direction of the control substrate 60 that is opposite from the surface facing the power substrate 20. The connecting portion 67 is a female connector into which a connector that connects a control device controlling the semiconductor apparatus 10 (higher-level control device) with the semiconductor apparatus 10 is inserted.

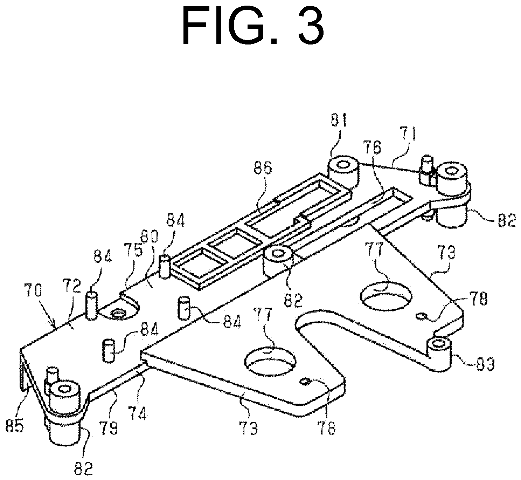

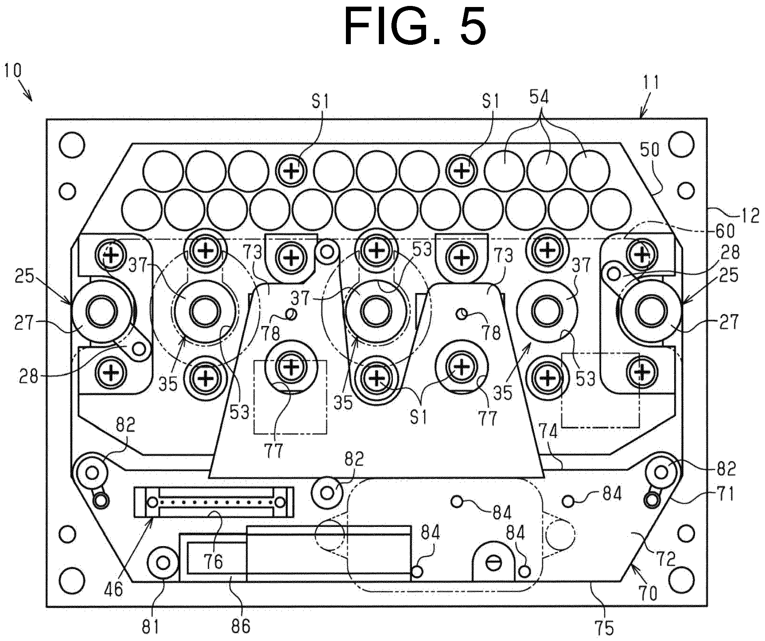

As shown in FIGS. 1, 3, and 5, the semiconductor apparatus 10 includes a bracket 70 that fixes the control substrate 60 to the heat sink 11. The bracket 70 is provided to fix the control substrate 60 to the heat sink 11 with the capacitor substrate 50 and the control substrate 60 maintaining the spaced distance therebetween. The bracket 70 is made of a metal such as aluminum and copper.

The bracket 70 includes a body portion 71. The body portion 71 includes a base portion 72 having a square plate shape, two interposed portions 73 projecting from the base portion 72 in the direction along the surfaces of the base portion 72 in the thickness direction (the direction extending perpendicularly to the thickness direction). The two interposed portions 73 extend in the same direction from the base portion 72. One of the opposite ends of the base portion 72 in the above-described direction extending perpendicularly to the thickness direction of the base portion 72 is defined as a first end 74 and the other as a second end 75, and the interposed portion 73 extends from the first end 74 of the base portion 72. A pin-header insertion hole 76 is formed through the base portion 72 in the thickness direction thereof. The pin-header 46 is inserted through the pin-header insertion hole 76. Each of the two interposed portions 73 is formed with a through hole 77 and a check hole 78 formed through the interposed portion 73 in the thickness direction thereof. Both the through hole 77 and the check hole 78 have a circular shape. The check hole 78 is disposed closer to the tip of the interposed portion 73 than the through hole 77 is. The diameter of the check hole 78 is smaller than that of the through hole 77.

The opposite surfaces of the body portion 71 in the thickness direction thereof are defined as a first surface 79 and a second surface 80. The bracket 70 has a plurality of fastener bosses 81, 82, 83 projecting from the body portion 71 in the thickness direction of the body portion 71. In the present embodiment, the plurality of fastener bosses 81, 82, 83 includes one first fastener boss 81, three second fastener bosses 82, and one third fastener boss 82. The first fastener boss 81 and the second fastener boss 82 project from both the first and second surfaces 79, 80 of the body portion 71 in the thickness direction thereof. The third fastener boss 83 projects from the second surface 80 of the body portion 71. The first fastener boss 81 and the second fastener boss 82 are formed in the base portion 72. The third fastener boss 83 is formed in the interposed portion 73.

The projecting dimension of the first fastener boss 81 from the first surface 79 is greater than that of the second fastener boss 82 from the first surface 79. Specifically, the first fastener boss 81 projects from the first surface 79 greater than the second fastener boss 82 by the thickness dimension of the power substrate 20. The projecting dimension of the first fastener boss 81 from the second surface 80 and the projecting dimension of the second fastener boss 82 from the second surface 80 are substantially the same. The first fastener boss 81, the second fastener boss 82, and the third fastener boss 83 have a cylindrical shape.

The bracket 70 includes four support portions 84 that project from the second surface 80 of the body portion 71. The support portions 84 projects toward the surface of the opposite surfaces of the control substrate 60 in the thickness direction of the second substrate that faces the bracket 70. The support portions 84 are formed in the base portion 72 of the body portion 71 of the bracket 70. In the present embodiment, the support portions 84 are disposed at the four corners of an imaginary parallelogram formed by connecting the support portions 84 with straight lines. The support portions 84 have a cylindrical shape. The projecting dimension of the support portion 84 from the second surface 80 is substantially the same as that of the first fastener boss 81 from the second surface 80.

The bracket 70 has a projecting portion 85 projecting from the first surface 79 of the body portion 71. The projecting portion 85 extends along the second end 75 of the base portion 72. In the present embodiment, the projecting portion 85 extends over the entire second end 75.

The bracket 70 includes a placement portion 86 having a frame shape and projecting from the second surface 80 of the body portion 71. The placement portion 86 is disposed between the support portion 84 and the first fastener boss 81. The placement portion 86 is disposed along the second end 75.

The bracket 70 is disposed between the power substrate 20 and the control substrate 60. Specifically, the base portion 72 of the bracket 70 is disposed between the power substrate 20 and the control substrate 60, and the interposed portion 73 is interposed between the capacitor substrate 50 and the control substrate 60. In addition, the bracket 70 is disposed so that first surface 79 of the body portion 71 faces the heat sink 11 and the power substrate 20 and the second surface 80 of the body portion 71 faces the control substrate 60.

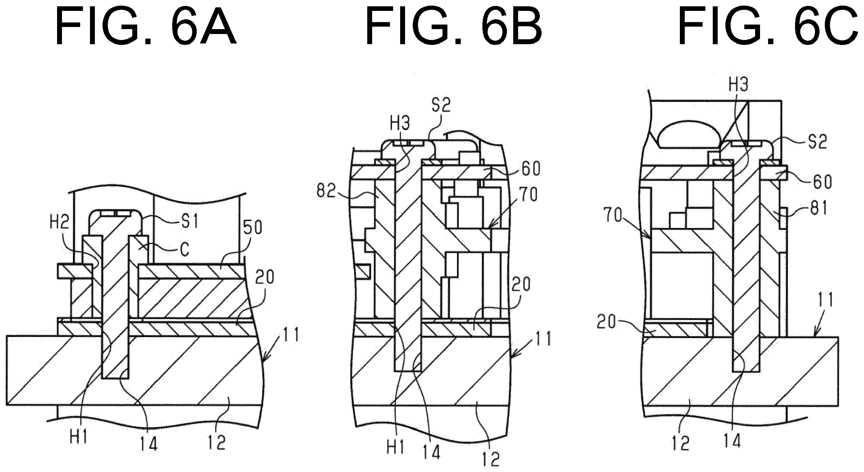

As shown in FIGS. 6A, 6B, and 6C, one of the axial end surfaces of the first fastener boss 81 is in surface contact with the fixing member 12, and the other of the axial end surfaces of the first fastener boss 81 is in surface contact with the control substrate 60. One of the axial end surfaces of the second fastener boss 82 is in surface contact with the power substrate 20, and the other of the axial end surfaces of the second fastener boss 82 is in surface contact with the control substrate 60. In other words, the second fastener boss 82 is indirectly in contact with the heat sink 11 through the power substrate 20 in the present disclosure. The second fastener boss 82 serves as the indirect heat transfer portion in contact with the power substrate 20. The axial end surface of the third fastener boss 83 is in surface contact with the control substrate 60. A spaced distance between the control substrate 60 and the heat sink 11 is maintained with the control substrate 60 supported by the fastener bosses 81, 82, 83. The projecting portion 85 is in surface contact with the fixing member 12 of the heat sink 11. The first fastener boss 81 and the projecting portion 85 serve as the direct heat transfer portion in contact with the heat sink 11 of the present disclosure.

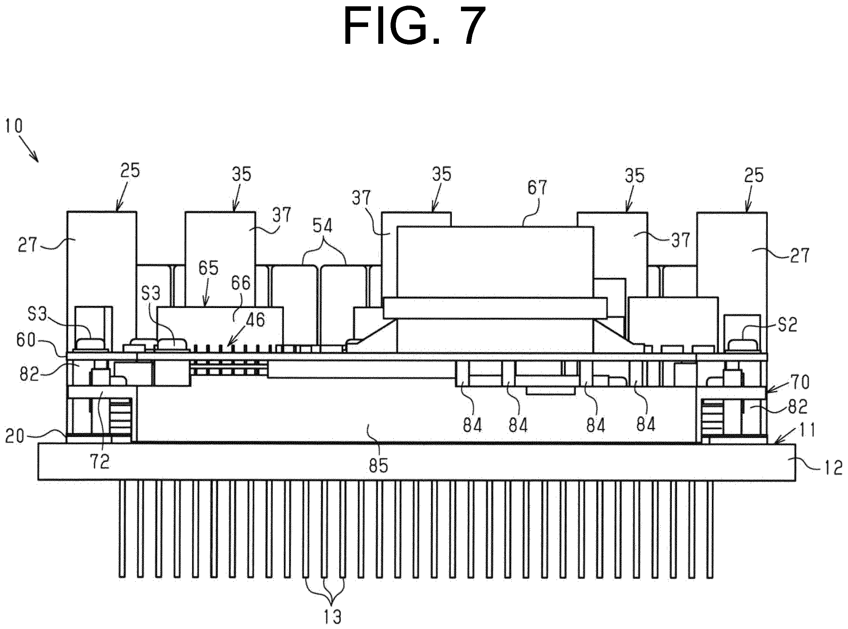

As shown in FIG. 7, the support portions 84 are in contact with the control substrate 60 at positions where the connecting portion 67 is formed. That is, the support portions 84 are disposed at a position facing a portion of the control substrate 60 where the connecting portion 67 is formed. In other words, the support portions 84 face the connecting portion 67 across the control substrate 60. It is to be noted that the portions of the power substrate 20, the capacitor substrate 50, and the control substrate 60 to be in contact with the fastener bosses 81, 82, 83 are where no electric current flows.

The semiconductor apparatus 10 includes a heat transfer member 91 that is disposed between the bracket 70 and the control substrate 60, and an interposed heat transfer member 92 that is disposed between the bracket 70 and the capacitor substrate 50. The heat transfer member 91 is held between the placement portion 86 and a portion of the control substrate 60 facing the placement portion 86. The heat transfer member 91 is disposed in the frame-shaped placement portion 86. Each interposed heat transfer member 92 is held between its associated interposed portion 73 and the capacitor substrate 50. Each interposed heat transfer member 92 is disposed at a position facing the portion of the interposed portion 73 of the bracket 70 where the check hole 78 is formed. The heat transfer member 91 and the interposed heat transfer member 92 are positioned where the electric current is intensified and near the electronic components 63 which generate heat.

The heat transfer member 91 and the interposed heat transfer member 92 are electrically non-conductive and formed from a heat transfer sheet which is deformed by the application of pressure. For example, a silicon-based heat transfer sheet is used for the heat transfer member 91 and the interposed heat transfer member 92. The application of the pressure from the control substrate 60 and the bracket 70 deforms the heat transfer member 91 in a shape corresponding to the surfaces of the control substrate 60 and the bracket 70. Thus, the heat transfer member 91 is closely in contact with the control substrate 60 and the bracket 70. The application of the pressure from the capacitor substrate 50 and the bracket 70 deforms the interposed heat transfer member 92 into a shape corresponding to the surface of the capacitor substrate 50 and the bracket 70. Thus, the interposed heat transfer member 92 is closely in contact with the capacitor substrate 50 and the bracket 70.

As shown in FIG. 1, the semiconductor apparatus 10 includes a plurality of screws S1, S2, S3 for fixing the power substrate 20, the control substrate 60, the capacitor substrate 50 to the heat sink 11, and a plurality of electrically non-conductive collars C. The plurality of screws S1, S2, S3 includes a plurality of first screws S1, a plurality of second screws S2, and a plurality of third screws S3.

As shown in FIGS. 6A, 6B, and 6C, the first screws S1 are inserted through the second insertion holes H2 of the capacitor substrate 50 and the first insertion holes H1 of the power substrate 20 with the collars C and fastened to the screw holes 14 of the heat sink 11, respectively. Thus, the power substrate 20 and the capacitor substrate 50 are fastened together by the first screw S1. Some of the first screws S1 are inserted through the spacer 40, the base portion 26 of the input terminal 25, or the base 36 of the output terminal 35 as well as the power substrate 20 and the capacitor substrate 50.

Some of the second screws S2 are inserted through the third insertion holes H3 of the control substrate 60 and the first fastener bosses 81 and fastened to the screw holes 14 of the heat sink 11. Thus, the control substrate 60 and the bracket 70 are fastened together by the second screws S2. Some of the second screws S2 are inserted through the third insertion holes H3 of the control substrate 60, the second fastener bosses 82, and the first insertion hole H1 of the power substrate 20, and are fastened to the screw holes 14 of the heat sink 11. Thus, the control substrate 60, the bracket 70, and the power substrate 20 are fastened together by the second screws S2.

As shown in FIG. 1, some of the third screws S3 are inserted through the third insertion hole H3 of the control substrate 60 and fastened to the third fastener boss 83. Some of the third screws S3 is inserted through the third insertion hole H3 of the control substrate 60 and fastened to the seat portion 28 of the input terminal 25. Thus, the control substrate 60 is fixed to the bracket 70 and the input terminal 25.

The following will describe assembling the power substrate 20, the capacitor substrate 50, the control substrate 60, the heat transfer member 91, the interposed heat transfer member 92, and the bracket 70 to the heat sink 11. It is noted that the description of assembling other members forming the semiconductor apparatus 10 other than the above-mentioned members will be omitted.

Firstly, the power substrate 20 is placed on the heat sink 11. Then, the capacitor substrate 50 is disposed at a position facing the power substrate 20. The power substrate 20 and the capacitor substrate 50 are fixed to the heat sink 11 by fastening the first screw S1. The interposed heat transfer member 92 is disposed on the capacitor substrate 50. The interposed heat transfer member 92 is disposed on the conductor pattern 52 of the capacitor substrate 50. Thus, the interposed heat transfer member 92 is disposed on the capacitor substrate 50 with the conductor pattern 52 serving as a mark for the position of the interposed heat transfer member 92.

Then, the bracket 70 is disposed. The interposed heat transfer member 92 may be checked through the check hole 78 after the placement of the bracket 70. Accordingly, the presence or the absence of the interposed heat transfer member 92 may be checked after disposing the bracket 70.

Then, the heat transfer member 91 is placed in the placement portion 86 of the bracket 70 so that the heat transfer member 91 is disposed in the frame-shaped placement portion 86. Accordingly, the heat transfer member 91 is securely positioned and is less likely to be misplaced.

Subsequently, the control substrate 60 is disposed at a positon facing the bracket 70, and then, the second and third screws S2, S3 are fastened to the heat sink 11. Accordingly, the assembling of the semiconductor apparatus 10 is carried out.

The following will describe the operational effects of the semiconductor apparatus 10 of the present embodiment. When the semiconductor apparatus 10 is operated to drive the three-phase motor, heat is generated from the semiconductor devices 24, the electronic components 63, and the conductor patterns 22, 52. The heat generated by the semiconductor devices 24 and the power substrate 20 is transferred from the power substrate 20 to the heat sink 11.

The electronic component 63 and the control substrate 60 forming the control circuit generate heat, which is transferred to the bracket 70 through the heat transfer member 91. Since the heat transfer member 91 is disposed near the first fastener boss 81 and the projecting portion 85, most of the heat transferred from the heat transfer member 91 is transferred to the heat sink 11 through the first fastener boss 81 and the projecting portion 85. The heat transfer member 91 is disposed closer to the first fastener boss 81 and the projecting portion 85 than to the second fastener boss 82 is. Additionally, the heat generated from the electronic component 63 and the control substrate 60 forming the control circuit is transferred to the heat sink 11 through the second fastener boss 82 and the power substrate 20.

Heat generated from the capacitor 54 and the capacitor substrate 50 is transferred through the input terminal 25, the output terminal 35, and the spacer 40 to the power substrate 20, which is then transferred to the heat sink 11. Additionally, heat generated by the capacitor 54 and the capacitor substrate 50 is transferred through the interposed heat transfer member 92 to the bracket 70, which is then transferred through the fastener bosses 81, 82 to the heat sink 11.

As has been described, the fastener bosses 81, 82 and the projecting portion 85 serve as the heat transfer portion and are operable to transfer heat from the control substrate 60 and the capacitor substrate 50 to the heat sink 11. Accordingly, heat is released from the control substrate 60 and the capacitor substrate 50.

When the connector is to be inserted into the connecting portion 67, force applied from the connector to the connecting portion 67 is applied to the control substrate 60, which may bend the control substrate 60. However, the support portion 84 is disposed in a direction in which the control substrate 60 may be bent by such force, so that the bending of the control substrate 60 may be restricted by the support portion 84.

If the support portions 84 are disposed at the four corners of an imaginary rectangular shape formed by connecting the support portions 84, the actual area for mounting the control substrate 60 is reduced due to a need for the insulation distance. According to the present embodiment, disposing the support portions 84 at the four corners of the imaginary parallelogram formed by connecting the support portions 84 may suppress the reduction of the actual area for mounting the control substrate 60.

The following effects may be accomplished according to the above-described embodiment of the present disclosure.
(1) Since the bracket 70 is made of a metal, the bracket 70 may be used as a heat transfer passage for transferring heat from the control substrate 60 to the heat sink 11. In addition, the use of the heat transfer member 91 that is electrically non-conductive for transferring heat from the control substrate 60 to the bracket 70 may prevent short circuit between the control substrate 60 to the bracket 70, which may occur due to the use of the metal bracket 70. Thus, the bracket 70 that is provided for fixing the control substrate 60 to the heat sink 11 may be also used as a member that transfers heat to the heat sink 11. As compared with the case in which the bracket 70 is not used as a heat transfer passage and an additional member (e.g. a metal plate) other than the bracket 70 is provided as a heat transfer passage, an increase in size of the semiconductor apparatus 10 may be suppressed.
(2) The first fastener boss 81 and the projecting portion 85 of the bracket 70 are in contact with the heat sink 11. Thus, heat is more easily transfer from the bracket 70 to the heat sink 11, as compared with the case in which heat is transferred to the heat sink 11 through any other members. The heat release performance of the control substrate 60 may be increased by providing the first fastener boss 81 and the projecting portion 85.
(3) The heat transfer member 91 is disposed closer to the first fastener boss 81 and the projecting portion 85 than the second fastener boss 82 is. As has been described, heat is more easily transferred to the heat sink 11 by the first fastener boss 81 and the projecting portion 85 than by the second fastener boss 82. Disposing the heat transfer member 91 at a position near the first fastener boss 81 and the projecting portion 85 may shorten the heat transfer passage from the heat transfer member 91 to the first fastener boss 81 and the projecting portion 85. As a result, the heat release performance of the control substrate 60 may be increased.
(4) The bracket 70 includes the placement portion 86 that specifies the position of the heat transfer member 91. The placement portion 86 may be used as a mark for the position of the heat transfer member 91 in positioning the heat transfer member 91. The misplacement of the heat transfer member 91 may be prevented by disposing the placement portion 86 as a frame for positioning the heat transfer member 91.
(5) The interposed heat transfer member 92 is disposed between the interposed portion 73 of the bracket 70 and the capacitor substrate 50. This configuration allows heat to be transferred from the capacitor substrate 50 to the bracket 70, and thus the heat release performance of the capacitor substrate 50 is increased.
(6) The bracket 70 has the check hole 78. After the bracket 70 is assembled to the heat sink 11, it becomes difficult to see the interposed heat transfer member 92 that is disposed between the interposed portion 73 of the bracket 70 and the capacitor substrate 50. Providing the check hole 78 in the bracket 70 at a position facing the interposed heat transfer member 92 permits checking the presence or the absence of the interposed heat transfer member 92 after the bracket 70 is assembled to the heat sink 11.
(7) The support portions 84 of the bracket 70 suppress the bending of the control substrate 60 when inserting the connector into the connecting portion 67. As a result, the bending of the control substrate 60 and the application of pressure at the joining part of the electronic components 63 are less likely to occur.

The above-described embodiment of the present disclosure may be modified in various manners, as exemplified below.

The projecting dimension of the support portion 84 from the second surface 80 may be smaller than that of the first fastener boss 81 from the second surface 80. In this case, the support portion 84 is not in contact with the control substrate 60, and a space is formed between the support portion 84 and the control substrate 60. The control substrate 60 is brought into contact with the support portions 84, if the control substrate 60 is bent in inserting the connector. In other words, if there is a space between the support portion 84 and the control substrate 60, the bending of the control substrate 60 is permitted in such space, but is restricted by the contact between the control substrate 60 and the support portion 84. In other words, the formation of a small space between the support portion 84 and the control substrate 60 is allowed if such small space is smaller than the allowable bending amount of the control substrate 60.

The positions of the support portions 84 may be changed appropriately. For example, the support portions 84 may be disposed at the four corners of an imaginary rectangular shape formed by connecting the support portions 84. In addition, the number of the support portions 84 may be changed appropriately.

The bracket 70 need not necessarily be configured to support the support portion 84.

The bracket 70 need not have the check hole 78. In such case, the semiconductor apparatus 10 may be formed so that the presence or the absence of the interposed heat transfer member 92 without the check hole 78. For example, the semiconductor apparatus 10 is formed so that the interposed heat transfer member 92 may be checked through a space between the capacitor substrate 50 and the bracket 70, or so that a part of the interposed heat transfer member 92 projects from a space between the interposed portion 73 and the capacitor substrate 50.

The bracket 70 need not necessarily include the interposed portion 73 and the interposed heat transfer member 92 as long as heat generated from the capacitor substrate 50 is sufficiently released through the spacer 40 and the input terminal 25. In this case, the bracket 70 need not include the indirect heat transfer portion but have the first fastener boss 81 and the projecting portion 85, which serve as the direct heat transfer portion.

The placement portion specifying the position of the heat transfer member 91 may be a recess, a hole, a projection, or a pattern provided in or on the bracket 70.

The bracket 70 need not necessarily include the placement portion 86.

The heat transfer member 91 may be positioned closer to the second fastener boss 82 than the first fastener boss 81 and the projecting portion 85 are.

The bracket 70 need not necessarily include the first fastener boss 81 and the projecting portion 85, but may only include the second fastener boss 82, i.e., the indirect heat transfer portion, as a heat transfer portion.

The bracket 70 may be provided with one of the first fastener boss 81 and the projecting portion 85 as the direct heat transfer portion.

The bracket 70 may have any shape as long as the control substrate 60 is supported by the bracket 70 and heat is transferred from the control substrate 60 to the heat sink 11.

As a heat release member, a heat release plate having no fin 13 may be used. The heat release member may be cooled by refrigerant gas or refrigerant liquid.

The substrates 20, 50, 60 may be provided by any type of substrates such as an electrically non-conductive metal substrate and a print substrate.

The semiconductor apparatus 10 is not limited to an inverter. For example, the semiconductor apparatus 10 may be an electric converter device other than the inverter such as a converter. In addition, the semiconductor apparatus 10 may be formed with the semiconductor device 24 other than the switching device (e.g. diode). As long as the semiconductor apparatus 10 is provided with the first substrate fixed to the heat release member and the second substrate spaced from the first substrate, the number of the substrates in the semiconductor apparatus 10 may be changed. For example, the semiconductor apparatus 10 need not include three substrates as in the above-described embodiment, but may include only two substrates, namely, the first substrate and the second substrate.

The semiconductor apparatus 10 need not necessarily be mounted to an industrial vehicle.

A semiconductor apparatus (10) includes a heat release member (11), a first substrate (20) that is fixed to the heat release member (11) and on which a semiconductor device (24) is mounted, a second substrate (60) that is spaced from the first substrate (20) in a thickness direction of the first substrate (20) and on which an electronic component is mounted, and a bracket (70) that fixes the second substrate (60) to the heat release member (11). An electrically non-conductive heat transfer member (91) is disposed between the second substrate (60) and the bracket (70) for transferring heat from the second substrate (60) to the bracket (70). The bracket (70) is made of a metal. The bracket (70) includes a heat transfer portion (81, 82, 85) that transfers heat to the heat release member (11).

## Claims

1. A semiconductor apparatus (10) comprising:
a heat release member (11);
a first substrate (20) that is fixed to the heat release member (11) and on which a semiconductor device (24) is mounted;
a second substrate (60) that is spaced from the first substrate (20) in a thickness direction of the first substrate (20) and on which an electronic component (63) is mounted; and
a bracket (70) that fixes the second substrate (60) to the heat release member (11),
**characterized in that**
an electrically non-conductive heat transfer member (91) is disposed between the second substrate (60) and the bracket (70) that transfers heat from the second substrate (60) to the bracket (70),
the bracket (70) is made of a metal, and
the bracket (70) includes a heat transfer portion (81, 82, 85) that transfers heat to the heat release member (11).

2. The semiconductor apparatus (10) according to claim 1, **characterized in that** the heat transfer portion (81, 82, 85) includes a direct heat transfer portion (81, 85) that is in contact with the heat release member (11).

3. The semiconductor apparatus (10) according to claim 2, **characterized in that** the heat transfer portion (81, 82, 85) includes an indirect heat transfer portion (82) in contact with the first substrate (20), and the heat transfer member (91) is disposed closer to the direct heat transfer portion (81, 85) than to the indirect heat transfer portion (82) is.

4. The semiconductor apparatus (10) according to any one of claims 1 through 3, **characterized in that** the bracket (70) includes a placement portion (86) that specifies a position of the heat transfer member (91).

5. The semiconductor apparatus (10) according to any one of claims 1 through 4, **characterized in that** a third substrate (50) is disposed between the first substrate (20) and the second substrate (60), the bracket (70) includes an interposed portion (73) that is interposed between the second substrate (60) and the third substrate (50), and an electrically non-conductive interposed heat transfer member (92) that transfers the heat from the third substrate (50) to the bracket (70) is disposed between the third substrate (50) and the interposed portion (73).

6. The semiconductor apparatus (10) according to claim 5, **characterized in that** the interposed portion (73) has a check hole (78) at a position facing the interposed heat transfer member (92).

7. The semiconductor apparatus (10) according to any one of claims 1 through 6, **characterized in that** a connecting portion (67) is provided on a surface of opposite surfaces of the second substrate (60) in a thickness direction of the second substrate (60) that is opposite from the surface facing the bracket (70) to which a connector is inserted, the bracket (70) includes a support portion (84) that projects toward the surface of the opposite surfaces of the second substrate (60) in the thickness direction of the second substrate (60) that faces the bracket (70), and the support portion (84) is disposed at a position facing a portion of the second substrate (60) where the connecting portion (67) is formed.
